# EUROPEAN PATENT SPECIFICATION

(11) **EP 4 327 040 B1**
(45) Date of publication and mention of the grant of the patent: **05.03.2025**
(21) Application number: 21765970.5
(22) Date of filing: 28.07.2021
(51) Int. Cl.: F28F 1/42, F28F 5/00

(54) **COOLING APPARATUS, SYSTEM AND METHOD OF MANUFACTURE**
KÜHLVORRICHTUNG, SYSTEM UND HERSTELLUNGSVERFAHREN
APPAREIL DE REFROIDISSEMENT, SYSTÈME ET PROCÉDÉ DE FABRICATION

(30) Priority: 19.04.2021 GB 202105589
(43) Date of publication of application: 28.02.2024
(73) Proprietor: Katrick Technologies Limited, Glasgow G1 1RE (GB)
(72) Inventor: VELAYUTHAM, Karthikeyan, Glasgow G1 1RE (GB)
(74) Representative: Leyland, Matthew John
(86) International application number: PCT/GB2021/051950
(87) International publication number: WO 2022/223938

(56) References cited:
- JP-A- S61 186 785
- US-A1- 2006 162 903
- US-A1- 2013 105 122
- US-A1- 2014 068 942
- US-A1- 2018 246 550

## Description

The present invention relates to a cooling apparatus, system and method of manufacture. In particular, the described cooling apparatus is suitable for reducing the temperature of an environment which normally employs air conditioning apparatus e.g. a data centre.

### Background to the Invention

A vapour-compression refrigeration system comprises a working fluid which undergoes repeated phase transitions cycling between a liquid and a gas. This type of refrigeration system has numerous applications, ranging from domestic fridges and freezers to air conditioning systems for buildings. US 2013/105122 discloses a cooling apparatus having the features of the preamble of claim 1.

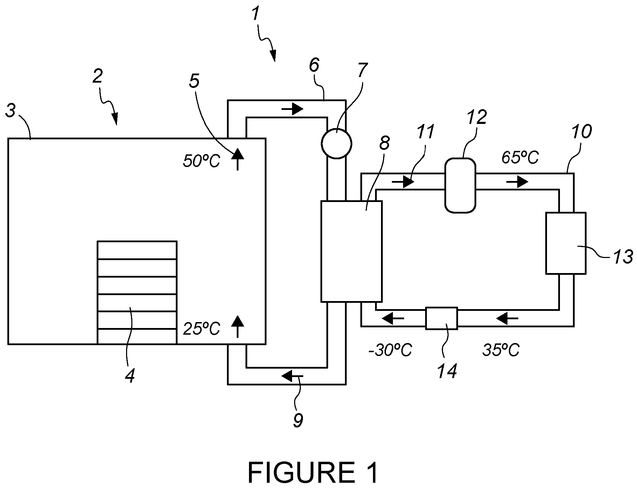

Figure 1 depicts a vapour-compression refrigeration system 1 known in the art used to cool a data centre 2. The data centre 2 takes the form of a building 3 housing computer systems 4. The temperature within the building 3 is often raised above ambient temperature to, for example, 50 °C due to the operation of the computer systems 4. The purpose of the vapour-compression refrigeration system 1 is to lower the temperature within the building 3 such that the computer systems 4 do not overheat.

High temperature (50 °C) air 5 within the building 3 is drawn into circulation loop 6, by means of a circulation fan 7. Whilst traversing the circulation loop 6, the high temperature air 5 passes through an evaporator 8 and loses heat. The resulting low temperature air 9 with a temperature of 25 °C is pumped into the building 3.

The evaporator 8 is part of a sealed refrigeration loop 10 which contains a working fluid 11, commonly known as a refrigerant. The evaporator 8 transfers heat from the high temperature air 5 to the working fluid 11. As such, the evaporator 8 can more generally be considered a heat exchanging apparatus. The heat induces a phase change in the working fluid 11 from a liquid to a gas. The gaseous working fluid 11 circulates about the refrigeration loop 10 where it is then compressed by a compressor 12 resulting in a temperature increase of the gaseous working fluid 11 up to, for example, 65 °C. The hot (65 °C) compressed working fluid 11 is then cooled in a condenser 13 such that the gaseous working fluid 11 expels heat and condenses back to a liquid, resulting in a liquid compressed working fluid 11 with a reduced temperature of, for example, 35 °C. After which, the temperature of the liquid working fluid 11 is reduced further to, for example, -30 °C by reducing the pressure of the liquid compressed working fluid 11 by means of an expansion valve 14. The cold (-30 °C) uncompressed working fluid is recirculated into the evaporator where, by means of thermal diffusion, heat again transfers from the high temperature air 5 to the working fluid 11. The cycle repeats continually cooling the high temperature air 5 originating from the building 3.

The vapour-compressed refrigeration system 1 as depicted in Figure 1 requires electrical power to operate. In particular, the circulating fan 7, compressor 12 and condenser 13 all draw electrical power. Disadvantageously, such systems 1 can draw significant amounts of electrical power. A relatively large data centre can equate to electrical power requirements equivalent to a town. Such a large electrical power consumption is expensive and also has a significant environmental impact.

Another disadvantage of the vapour-compressed refrigeration system 1 is that all the components, in particular the circulating fan 7, compressor 12 and condenser 13, require maintenance. This is an additional financial burden and the vapour-compressed refrigeration system 1 cannot operate during the required maintenance breaks.

### Summary of the Invention

It is an object of an aspect of the present invention to provide a cooling system that obviates or at least mitigates one or more of the aforesaid disadvantages of the cooling systems known in the art.

According to a first aspect of the present invention there is provided a cooling apparatus as provided by claim 1. Optional features are provided by dependent claims 2 to 7.

According to a second aspect of the present invention there is provided a cooling system as provided by claim 8. Optional features are provided by dependent claims 9 to 12.

Embodiments of the second aspect of the invention may comprise features to implement the preferred or optional features of the first aspect of the invention or vice versa.

According to a third aspect of the present invention there is provided a method of manufacturing a cooling apparatus as provided by claim 13. Optional features are provided by dependent claim 14.

Embodiments of the third aspect of the invention may comprise features to implement the preferred or optional features of the first and or second aspect of the invention or vice versa.

According to a fourth aspect of the present invention there is provided a method of manufacturing a cooling system comprising as provided by claim 15.

Embodiments of the fourth aspect of the invention may comprise features to implement the preferred or optional features of the first, second and or third aspects of the invention or vice versa.

### Brief Description of Drawings

There will now be described, by way of example only, various embodiments of the invention with reference to the drawings, of which:
Figure 1 presents a schematic representation of a cooling system known in the art;
Figure 2 presents a schematic representation of a cooling system in accordance with an embodiment of the present invention;
Figure 3 presents a schematic cross-sectional view of a cooling apparatus employed within the cooling system of Figure 2;
Figure 4 presents a cutaway perspective view of the cooling apparatus of Figure 3;
Figure 5 presents a perspective view of a rod employed within the cooling apparatus of Figure 3;
Figure 6 presents a schematic cross-sectional view of an alternative embodiment of the cooling apparatus of Figure 3;
Figure 7 presents a schematic representation of an alternative embodiment of the cooling system of Figure 2;
Figure 8 presents a schematic representation of a further alternative embodiment of the cooling system of Figure 2;
Figure 9 presents a schematic representation of yet another alternative embodiment of the cooling system of Figure 2;
Figure 10 presents a schematic representation of an alternative embodiment of the cooling system of Figure 2;
Figure **11** presents a schematic representation of an alternative embodiment of the cooling system of Figure 2;
Figure 12 presents a schematic representation of an alternative embodiment of the cooling system of Figure 2;
Figure 13 presents a schematic representation of an alternative embodiment of the cooling system of Figure 2;
Figure 14 presents a schematic representation of an alternative embodiment of the cooling system of Figure 2;
Figure 15 presents a schematic representation of an alternative embodiment of the cooling system of Figure 2;
Figure 16 presents a flow chart of the method of manufacturing the cooling apparatus of Figure 2;

In the description which follows, like parts are marked throughout the specification and drawings with the same reference numerals. The drawings are not necessarily to scale and the proportions of certain parts have been exaggerated to better illustrate details and features of embodiments of the invention.

### Detailed Description of the Preferred Embodiments

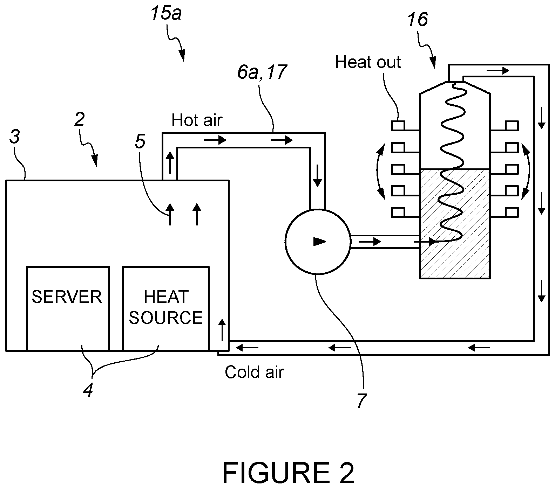

An explanation of the present invention will now be described with reference to Figures 2 to 16.

### Cooling System

Figure 2 depicts a cooling system 15a suitable for cooling a data centre 2 which takes the form of computer systems 4 housed within a building 3. The cooling system 15 comprises a cooling apparatus 16 and a heat transfer apparatus to transfer heat from the data centre 2 to the cooling apparatus 16. In the embodiment of Figure 2, the heat transfer apparatus takes the form of a circulation loop 6a and a circulation fan 7. The circulation fan 7 draws high temperature air 5 within the building 3 about the circulation loop 6a to the cooling apparatus 16.

More specifically, the circulation loop 6a comprises pipes 17 which channel high temperature air 5 to the cooling apparatus 16. The cooling apparatus 16 cools the high temperature air 5 resulting in low temperature air 9. The low temperature air 9 is circulated about the circulation loop 6a into the building 3 and cools the computer systems 4.

### Cooling apparatus

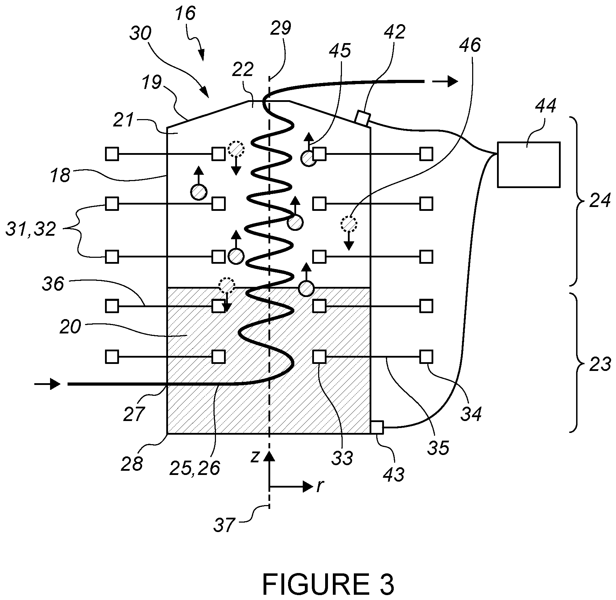

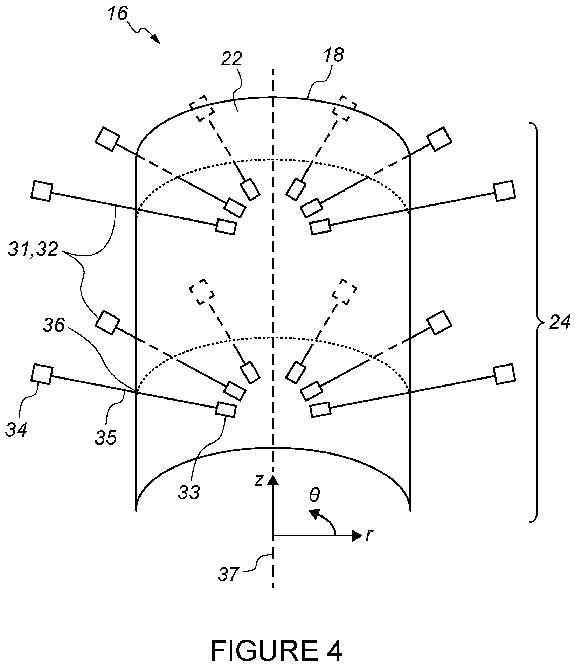

As can clearly be seen in Figure 2 to 4, the cooling apparatus 16 comprising a substantially cylindrical, sealable housing 18 with a substantially conical lid 19. The housing 18 comprises stainless steel, specifically, SA516 GR.65. For ease of understanding, Figures 3 and 4 depict a cylindrical coordinate system with r, θ, and z axes.

The cooling apparatus 16 can be seen to comprise a first liquid 20 and a second liquid 21 both of which are located within the housing 18. The first and second liquids 20, 21 occupy an interior volume 22 of the housing 18. The first liquid 20 has a higher density but lower boiling point in comparison to the second liquid 21. As such, whilst the first and second liquids 20, 21 are free to mix within the housing 18, the first liquid 20 locates within a first portion 23 of the housing 18, at the base of the housing 18, and the second liquid 21 locates within a second portion 24 of the housing 18, above the first liquid 20.

By way of example, the first liquid 20 may be trans-1-choloro-3,3,3-trifluoroprop-1-ene (R1233ZD), also referred to as trans chloro trifluoropropene, and the second liquid 21 may be de-mineralised water. The density of R1233ZD is approximately 1.3 times that of de-mineralised water and R1233ZD has a boiling point of 18.3 °C which is lower than the boiling point of demineralised water, 100 °C. A cooling apparatus 16 comprising R1233ZD and de-mineralised water as the first and second liquids 20, 21 is suitable for cooling high temperature air 5, over 19 °C, from a data centre 2. For the cooling apparatus 16 to operate, both the first and second liquids 20, 21 are required to be in liquid form at ambient temperature. As such, the ambient temperature of the environment surrounding the cooling apparatus 16 should be below the boiling point of the first and second liquids 20, 21, in this case, below 18.3 °C.

Further examples of the first and second liquids 20, 21 are provided in Table I along with an operating temperature range of a cooling apparatus 16 comprising the first and second liquids 20, 21. The combinations of the first and second liquids 20, 21 may be suited to different operational temperature ranges and system configurations. It will be appreciated that different operating temperature ranges to those detailed in Table I could be achieved by using different first and second liquids 20, 21 and different combinations of the first and second liquids 20, 21 beyond the disclosed liquids and combinations in Table I.

**Table I: Examples of: the first liquid; second liquid; a temperature range of the uncooled high temperature air suitable to be cooled by a cooling apparatus comprising the first and second liquids; example of uses of a cooling apparatus comprises the first and second liquid.**

| First Liquid | Second Liquid | Operating Temperature Range (°C) | Examples of Uses |
|---|---|---|---|
| 1-Chloro-3,3,3-trifluoropropene (Trans chloro trifluoropropene) R1233ZD (Boiling point: 18.3 °C) | De-mineralised water | Over 19 °C | Data centres, air conditioners, cooling rooms |
| Dichlorotrifluoroethane (Boiling point: 27.6 °C) | De-mineralised water | Over 28 °C | Data centres, air conditioners, cooling rooms |
| 1,2-Dichlorotetrafluoroethane (Boiling point: 3.5 °C) | De-mineralised water | Over 4 °C | Super cooled data centres, air conditioners, supercooling rooms |
| 1,1,1,3,3,3-Hexafluoropropane (Boiling point: -1.7 °C) | De-mineralised water | Over 0 °C | Super cooled data centres, air conditioners, supercooling rooms |
| R1234 YF (Boiling point: -29.29 °C) | De-mineralised water | Over - 20 °C | Freezer cycle, freezers |
| R-1234ze - (Trans-1,3,3,3-tetrafluoroprop-1-ène) (Boiling point: -18.89 °C) | De-mineralised water | Over -18 °C | Freezer cycle, freezers and low-temperature chillers |

The cooling apparatus 16 also comprises a heat exchanging apparatus 25 which transfers heat from the high temperature air 5 to the first liquid 20 (and second liquid 21) in order to evaporate a quantity of the first liquid 20. The first and second liquids 20, 21 are not directly exposed to the high temperature air 5 or any external fluid carrying heat from the data centre 2. In the embodiment of Figure 2 and 3, the heat exchanging apparatus 25 takes the form of a coiled pipe 26 extending along the z axis of the cooling apparatus 16.

More specifically, the coiled pipe 26 is located within the interior volume 22 of the housing 18. The coiled pipe 26 can be considered a portion of the air circulation loop 6a that directs high temperature air 5 through the cooling apparatus 16. The coiled pipe 26 comprises an inlet 27 towards the base end 28 of the housing 18 and an outlet 29 towards a top end 30 of the housing 18, in the conical lid 19.

The cooling apparatus 16 further comprises a plurality of independent energy dissipation members 31. As can be clearly seen in Figures 3 to 5, the plurality of independent energy dissipation members 31 take the form of rods 32. Each rod 32 comprises a first end 33, a second end 34 and a central mounting portion 35 between the first and second ends 33, 34. Each rod 32 extends through the housing 18. More specifically, the central mounting portion 35 of each rod 32 is mounted to the housing 18 by means of a bearing 36. The first end 33 of the each rod 32 extends into the interior volume 22 of the housing 18 towards a central axis 37 of the housing 18. The second end 34 is located external to the housing 18, extending radially away from the central axis 37 of housing 18. The first and second ends 33, 34 of each rod 32 are free to move. The bearing 36 translates any movement from the first end 33 to the second end 34 of each rod 32 (and vice versa). The rods 32 are independent in that each rod 32 is not mechanically coupled to any of the other rods 32. As such, the rods are independent and can move randomly relative to each other.

The rods 32 are distributed about of the housing 18 in both θ and z directions. The rods 32 are predominately located in the second portion 24 of the housing 18. Figures 2 to 4 depict the rods 32 as being uniformly distributed about the housing 18, orientated perpendicular to the housing 18 and all of uniform dimensions such as length.

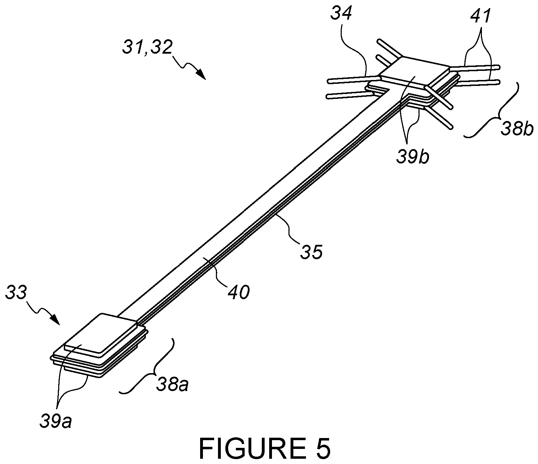

As can be seen from Figure 5 which depicts one of the rods 32, both the first and second ends 33, 34 comprise enlarged regions 38a, 38b with thermally conductive surfaces 39a, 39b. The thermally conductive surfaces 39a located on the enlarged region 38a at the first end 33 facilitate absorbing thermal energy by thermal diffusion from the liquids 20, 21 contained within the housing 18. The absorbed thermal energy can conduct along the rod 32 to the second end 34. The thermally conductive surfaces 39b located on the enlarged regions 38b at the second end 34 facilitate dissipating the thermal energy to the external surroundings of the cooling apparatus 16 through thermal diffusion. The thermally conductive surfaces 39a, 39b are made of the same material as the bulk of the rods 32.

The rods 32 may comprise a protective coating 40 which covers all but the thermally conductive surfaces 39a, 39b. It will be appreciated the thermally conductive surfaces 39a, 39b may be made of a different material such as pure copper which has a high thermal conductivity.

The rods 32 depicted in Figure 5, further comprises thermally conductive protrusions 41 protruding from the thermally conductive surfaces 39b at the second end 34. The thermally conductive protrusions 41 increase the surface area of the thermally conductive surfaces 39b and so increase the thermal energy dissipation capacity of the second end 34 of the rod 32.

It will be appreciated the dimensions, design, and composition of the rods 32 can be optimised to achieve the desired thermal dissipation properties. For example, the length of the rods 32, dimensions of the enlarged regions 38a, 38b, the thermally conductive surfaces 39a, 39b and or the inclusion of the thermally conductive protrusions 41 can be varied to increase or decrease the thermal dissipation properties of the rods 32.

The rods 32 are configured to operate randomly relative to each other. It will be further be appreciated the dimensions, design and material composition of each rod 32 may vary. Variations in the rods 32 may contribute to the relative random movement of the rods 32.

The housing 18 comprises a sealable inlet port 42 and a sealable outlet port 43. The sealable inlet port 42 is located at a top end 30 of the housing 18, through the second portion 24 of the housing 18 and provides a means for adding the first and second liquids 20, 21 into the housing 18. Similarly, the sealable outlet port 43 is located, at a base end 28 of the housing 18, through the first portion 23 of the housing 18 and provides a means for draining the first and second liquids 20, 21 from the housing 18. In order to fill and maintain the housing 18 at a positive pressure, the first and second liquids 20, 21 may be pumped to and from the housing 18 by a pumping system 44.

Figure 3 shows the cooling apparatus 16 of Figure 2 in operation, in other words cooling the high temperature air 5. The cooling apparatus 16 is a closed device such that the first and second liquids 20, 21 are not added or removed during operation. The heat exchanging apparatus 25, in other words the coiled pipe 26, transfers heat to the first liquid 20. As such, a portion of the first liquid 20 evaporates to form a first liquid vapour. The first liquid vapour takes the form of gaseous bubbles 45. The gaseous bubbles 45 have a lower density than both the first liquid 20 and the second liquid 21. As such, the gaseous bubbles 45 move in the positive z-direction, into the second portion 24 of the housing 18 and through the second liquid 21. The thermal energy from the high temperature air 5 is converted into kinetic energy in the form of the motion of the gaseous bubbles 45.

The interaction, in the form of relative motion and or thermal gradients, of the gaseous bubbles 45 and the second liquid 21 creates a fluid flow. More specifically, the fluid flow includes the flow of the first liquid 20, second liquid 21 and gaseous bubbles 45. For example, the fluid flow is depicted by the arrows in Figure 3. This fluid flow may be Laminar and or turbulent. The fluid flow induces the first end 33 of the rods 32 to move, oscillate and or vibrate. As such, the kinetic energy of the gaseous bubbles 45 is converted into mechanical energy. The Laminar fluid flow of the gaseous bubbles 45 may result in the gaseous bubbles 45 directly colliding with the first ends 33 of the rods 32, deflecting the rods 32. Furthermore, the turbulent fluid flow of the gaseous bubbles 45 and second liquid 21 may induce movement and or mechanical vibrations within the first ends 33 of the rods 32.

Each gaseous bubble 45 dissipates kinetic and thermal energy. As a result, each gaseous bubble 45 will eventually condense to form a liquid bubble 46 of the first liquid 20. The liquid bubbles 46 sink back towards the base end 28, into the first portion 23 of the housing 18 as the density of the liquid bubbles 46 is greater than the density of the second liquid 21. An advantage of the liquid bubbles 46 sinking back through the second portion 24 of the housing 18, is the liquid bubbles 46 may further create fluid flows and induce movement and or mechanical vibrations within the rods 32.

The motion induced in the first ends 33 of the rods 32 is transmitted by means of the bearing 36 to the second ends 34 of the rods 32. The heat absorbed by the first ends 33 of the rods 32 conducts along the rods 32 to the second ends 34. The mechanical and thermal energy at the second ends 34 of the rods 32 is dissipated to the surroundings of the cooling apparatus 16. As such, the cooling apparatus 16 cools the high temperature air 5. The resulting low temperature air 9 is circulated into the building 3 and cools the computer systems 2 of the data centre 2.

As an alternative embodiment, instead of being cylindrical, it will be appreciated that the housing 18 could take any regular or non-regular three-dimensional shape.

As an additional or alternative embodiment, it will be appreciated the cooling apparatus 16 comprises a third liquid. The cooling apparatus 16 may comprise multiple liquids.

As an additional or alternative embodiment, the distribution of the rods 32 about the housing 18 may be non-uniform. As another additional or alternative embodiment, the rods 32 may be orientated non-perpendicular to the housing 18. As a further additional or alternative embodiment, the dimensions, design, material composition, distribution, and orientation of the rods 32 may be computationally optimised.

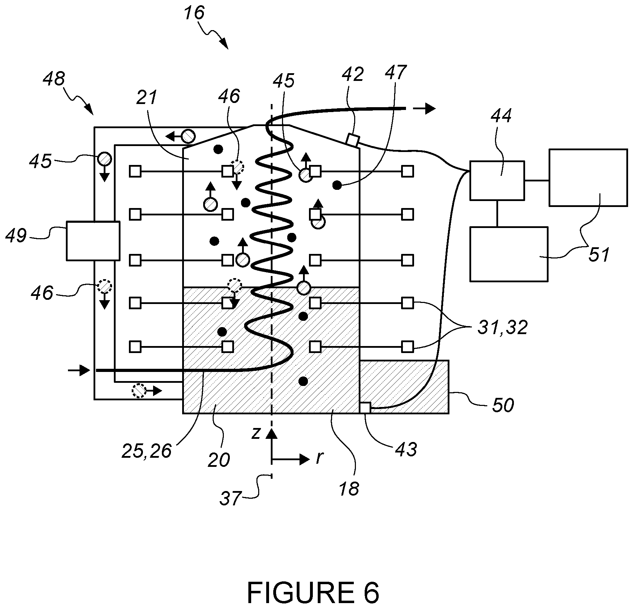

As an additional or alternative feature, the cooling apparatus 16 further comprises pellets 47. As can be seen in Figure 6, the pellets 47 are located within the interior volume 22 of the cooling apparatus 16 suspended within the first and second liquids 20, 21. The pellets 47 move about the interior volume 22 of the housing 18 in response to the fluid flow created by the interaction of the gaseous bubbles 45 and the second liquid 21. The pellets 47 collide with the rods 32 inducing further movement, or more specifically, mechanical vibrations within the rods 32, in addition to the movement induced directly by the fluid flow. The density of the pellets 47 is between the density of the first and second liquids 20, 21 such that the pellets 47 are not too heavy or buoyant when suspended within the first and second liquids 20, 21. Furthermore, the pellets 47 are chemically unreactive with the first liquid 20, second liquid 21 and gaseous bubbles 45. The pellets 47 are also preferably magnetically neutral. The dimensions and material composition of the pellets 47 may be optimised to achieve the desired interaction with the fluid flow.

As an additional or alternative embodiment, the cooling apparatus 16 of Figure 6, further comprises a condensing loop 48 with a condenser 49. Instead of the gaseous bubbles 45 passively condensing once they have lost sufficient energy within the housing 18, the condensing loop 48 actively condenses the gaseous bubbles 45. More specifically, once the gaseous bubbles 45 have traversed through the second portion 24 of the housing 18, the gaseous bubbles 16 pass through the condensing loop 48 where the condenser 49 actively cools the gaseous bubbles 45 such that they condense to liquid bubbles 46. The liquid bubbles 46 are returned to the first portion 23 of the housing 18. A condensing loop 48 may be advantageous if, for example, the cooling apparatus 16 is over heated such that the gaseous bubbles 45 accumulate at the top end 30 of the housing 18 and the level of the first liquid in the housing 18 decreases.

As another additional or alternative feature, the cooling apparatus 16 of Figure 6 further comprises a sink 50 of the first liquid 20. The sink 50 is connected to the housing 18 and maintains the level of the first liquid 20 within the first portion 23 of the housing 18. As the first liquid 20 evaporates within the cooling apparatus 16, this may induce non negligible changes in pressure and or volume within the cooling apparatus 16. The sink 50 minimises any changes in pressure and or volume.

As another additional or alternative feature, the cooling apparatus 16 of Figure 6 further comprises storage tanks 51. Each storage tank 51 comprises a different liquid such as those listed in Table 1 and the storage tanks are connected to the pumping system 44. The liquids may be compressed for storage within the storage tanks 51. The pumping system 44 facilitates removing the first and second liquids 20, 21 from the housing 18 to be stored within the respective storage tanks 51. The pumping system 44 can also facilitate replacing the first and second liquids 20, 21 with alternative combinations of liquids. As such, the combination of the first and second liquid 20, 21 can be optimised according to the operation conditions of the cooling apparatus 16. The process of removing and replacing the first and second liquids 20, 21 according to the operation requirements may be automated by the pumping system 44. As such the pumping system 44 may comprise sensors to monitor the cooling apparatus 16 and the surrounding conditions. Whilst Figure 6 depicts two storage tanks 51 it will be appreciated there may be a plurality of storage tanks 51 offering numerous alternative combinations of first and second liquids 20, 21.

The process of heat transfer to the first liquid 20, evaporation of the first liquid 20 to form gaseous bubbles 45, mechanical and thermal energy transfer from the gaseous bubbles 45 to the energy dissipation member (in other words the rods 32) and condensation of the gaseous bubbles 45 to form liquid bubbles 46 is repeated forming a cycle. The mechanical and thermal energy is continually dissipated by the cooling apparatus 16.

A key advantage of the cooling system 15a is that it requires less electrical energy to operate. In the embodiment of Figure 2, electrical power is only required to operate the circulation fan 7. The cooling system 15a does not comprise a compressor or a condenser. As such, the cooling system 15a cools the computer systems 4 of the data centre 2 using less electrical energy than conventional systems 1 known in the art. As such, the cooling system 15a is environmentally friendly. It is noted, the cooling apparatus 16 can operate without drawing any electrical power. As such, the cooling apparatus 16 may be considered a passive component.

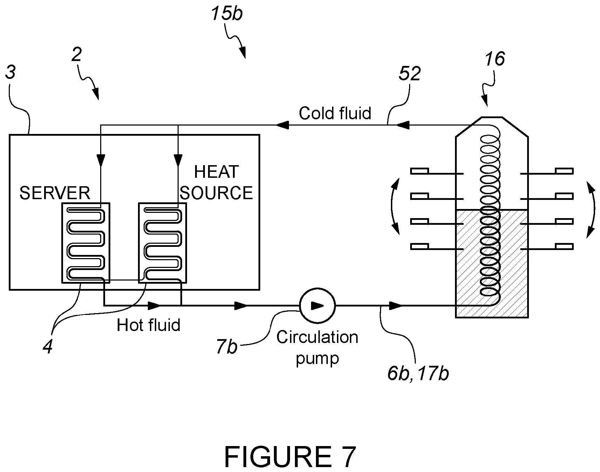

Figure 7 depicts an alternative cooling system 15b which may comprise the same preferable and optional features as the cooling system 15a as depicted in Figures 2 to 6.

However, instead of the circulation loop 6a of Figure 2, the heat transfer apparatus of the cooling system 15b of Figure 7 takes the form of a circulation loop 6b sealed within which is a fluid 52. The circulation loop 6b comprises pipes 17b which channel the fluid 52 to the computer systems 4. Heat is transferred from the computer systems 4 to the fluid 52 within the circulation loop 6b.

The pipes 17b in the vicinity of the computer systems 4 act as a heat exchanging apparatus and may be arranged to maximise the heat transfer from the computer systems 4 to the fluid 52. For example, the pipes 17b zigzag back and forth so as to take multiple passes by the computer systems 4, increasing the time the fluid 52 is exposed to the computer systems 4 and so maximising the heat transferred to the fluid 52.

A circulation pump 7b circulates the heated fluid 52 through the pipes 17b of the circulation loop 6b towards a cooling apparatus 16. The cooling apparatus 16 cools the heated fluid 52 and the resulting cooled fluid 52 is circulated back towards the computer systems 4 to absorb more heat. The process of absorbing heat from the computer systems 4, transferring the heat to the cooling apparatus 16 and dissipating the heat by means of the cooling apparatus 16 is repeated resulting in the continual cooling the computer systems 4

The fluid 52 sealed within the circulation loop 6b does not mix with air external to the circulation loop 6b such as air contained within the building 3. The fluid 52 can be any suitable fluid such as a refrigerant known in the art.

An advantage of the circulation loop 6b is that the fluid 52 may be as chosen according to the operational parameters of the cooling system 15b, for example the operational temperature range. Whilst the fluid 52 of the circulation loop 6b could be air, in contrast to circulation loop 6a, the circulation loop 6b is not limited to circulating air. As such, the fluid 52 of the circulation loop 6b may have desirable thermal and chemical properties to enhance the cooling system 15b. Furthermore, it may be financially more favourable to operate with a particular fluid 52 instead of air. In particular, the fluid 52 of the circulation loop 6b may not demand relatively more expensive, higher pressure apparatus required for operating with air.

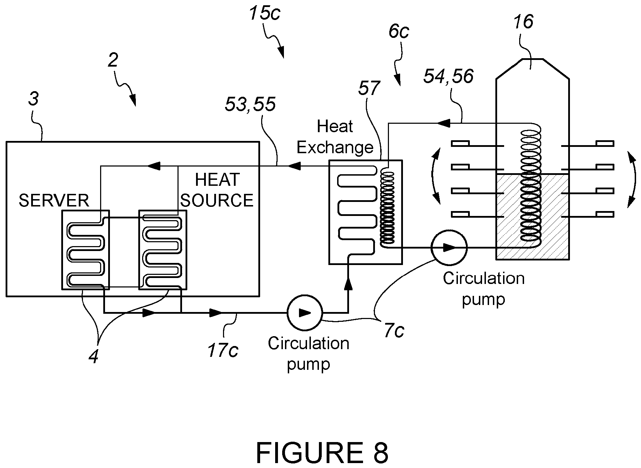

Figure 8 depicts an alternative cooling system 15c which may comprise the same preferable and optional features as the cooling systems 15a, 15b depicted in Figures 2 to 7.

However, instead of the circulation loops 6a, 6b of Figures 2 and 7, the heat transfer apparatus of the cooling system 15c of Figure 8 takes the form of a circulation loop 6c with a first loop 53 and a second loop 54. The first loop 53 comprises a first fluid 55. The first fluid 55 is sealed within the first loop 53. Similarly, the second loop 54 comprises a second fluid 56. The second fluid 56 is sealed within the second loop 54. The first and second fluids 55, 56 do not mix with each other nor air external to the circulation loop 6c. The first and second fluids 55, 56 are circulated about the first and second loops 53, 54 by circulation pumps 7c.

Heat from the computer systems 4 is transferred to the first fluid 55 of the first loop 53. Similar to the second embodiment of Figure 7, pipes 17c of the first loop 53 located in the vicinity of the computer systems 4 act as a heat exchanging apparatus and may be arranged to maximise the heat transfer from the computer systems 4 to the first fluid 55.

The first loop 53 transfers the heated first fluid 55 to a heat exchanging apparatus 57. The heat exchanging apparatus 57 transfers heat from the first fluid 55 of the first loop 53 to the second fluid 56 of the second loop 54. The second loop 54 transfers the heated second fluid 56 to a cooling apparatus 16 which cools the heated second fluid 56. The resulting cooled second fluid 56 is circulated back within the second loop 54 to the heat exchanging apparatus 57 where it cools the heated first fluid 55. Then, the cooled first fluid 55 is circulated back within the first loop 53 to computer systems 4 to repeat the cycle and reabsorb heat thereby continually cooling the computer systems 4.

The first and second fluids 55, 56 of the first and second loops 53, 54 may be the same or different. Again, like the second embodiment of Figure 7, the first and second fluids 55, 56 may be chosen according to the operation parameters of the cooling system 15c.

Advantageously, the cooling system 15c of Figure 8 is particularly suited for retrofitting existing cooling systems known in the art with a cooling apparatus 16. The first loop 53 of Figure 8 may exist as part of cooling systems known in art. As such, when retrofitting, only the second loop 54 and cooling apparatus 16 needs to be introduced. This can save considerable expense and time.

It will be appreciated that the circulation loop 6c of Figure 8 may additionally comprise a third loop and more generally a plurality of loops. Additional loops in conjunction with heat exchanging apparatus may help connect multiple data centres 2 and or multiple cooling apparatus 16 to the cooling system 15c.

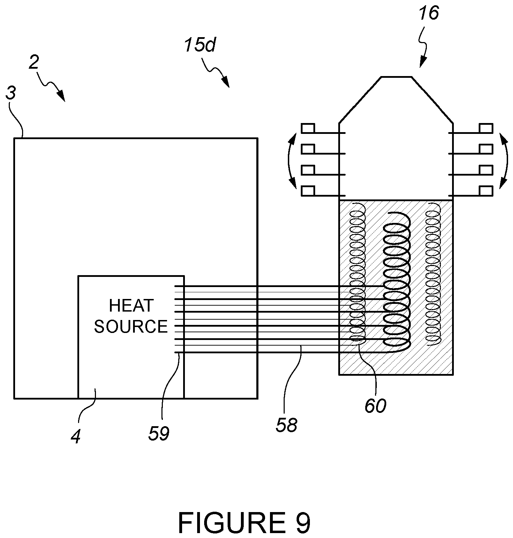

Figure 9 depicts a further alternative cooling system 15d which may comprise the same preferable and optional features as the cooling systems 15a, 15b, 15c depicted in Figures 2 to 8.

Instead of the circulation loops 6a, 6b, 6c of Figures 2 and 8, the heat transfer apparatus of the cooling system 15d of Figure 9 takes the form of conductive members 58, each conductive member 58 thermally connected at a first end 59 directly to the computer systems 4 and at a second end 60 to the cooling apparatus 16. The second ends 60 of the conductive members 58 extend through the housing 18 into the interior volume 22 of the cooling apparatus 16. As such the second ends 60 of the conductive members 58 are in direct thermal contact with the first and second liquids 20, 21 within the cooling apparatus 16. The conductive members 58 comprise a high conductive solid material such as pure copper.

In operation, heat is transferred or transported from the computer systems 4 of the data centre 2 to the cooling apparatus 16 by thermal diffusion along the conductive members 58. The second ends 60 of the conductive members 58 act as the heat exchanging apparatus 25 of the cooling apparatus 16 transferring the heat to the first and second liquids 20, 21 within the cooling apparatus 16. The cooling apparatus 16 dissipates the heat maintaining a thermal gradient across the conductive members 58. As such, heat is continually transferred to the cooling apparatus 16, cooling the computer systems 4.

Advantageously, the cooling system 15d of Figure 9 requires even less control and maintenance than the cooling systems 15a, 15b, 15c depicted in Figures 2 to 8. There is no high temperature air 5 nor fluid 52, 55, 56 circulating about a circulation loop 6a, 6b, 6c minimising the number of moving parts as well as negating the need for a pumping system 44 and storage tanks 51. The cooling system 15d of Figure 9 provides a solid-state solution to transfer the heat from the computer systems 4 to the cooling apparatus 16 as relies simply of thermal diffusion across the conductive members 58.

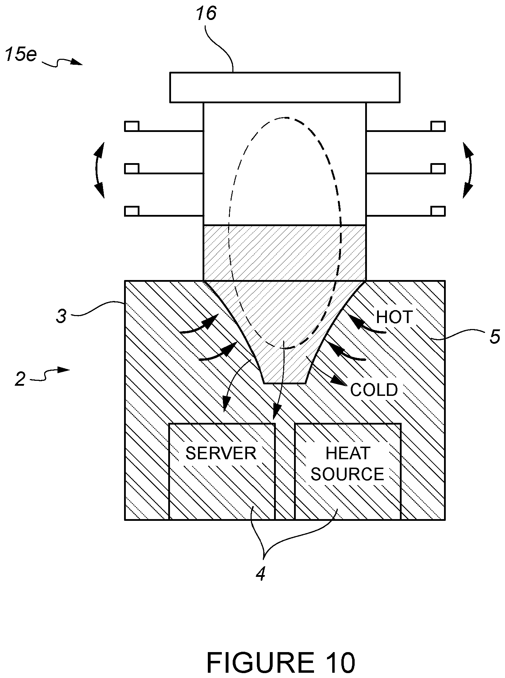

Figure 10 depicts an alternative cooling system 15e which may comprise the same preferable and optional features as the cooling systems 15a, 15b, 15c, 15d depicted in Figures 2 to 9.

Instead of the circulation loops 6a, 6b, 6c of Figures 2 and 8 or the conductive members 58 of Figure 9, the cooling system 15e of Figure 10 is configured such that a separate component to act as the heat transfer apparatus to transfer heat from the computer systems 4 to the cooling apparatus 16 is not required.

As can be seen from Figure 10, the cooling apparatus 16 is located upon the roof of the building 3. The first portion 16 of the housing 18 of the cooling apparatus 16 extends into the building 3 such that the first portion 16 is exposed to the high temperature air 5 within the building 3.

The cooling system 15e operates by convection currents in the air contained within the building 3. In operation, the heat from the computer systems 4 located on the floor of the building 3, rises to the roof of the building 3. The housing 18 of the cooling apparatus 16 acts as the heat exchanging apparatus 25 in that the high temperature air 5 transfers heat through the housing 18 to the first liquid 20 located within the housing 18. The heat transferred to the cooling apparatus 16 is dissipated. As such, the high temperature air 5 is cooled and sinks back to the floor of the building 3 where it can absorb heat for the computer systems 4. This process is repeated such that the computer systems 4 are continually cooled.

It will be appreciated that the operation of the cooling system 15e and specifically, the heat dissipation capacity, can be modified by varying the exposure of the cooling apparatus 16 to the high temperature air 5 within the building 3. In other words, if a greater proportion of the cooling apparatus 16 extends within the building 3 such that a greater proportion of the housing 18 is in thermal contact with the high temperature air 5, then the cooling apparatus 16 will absorb more heat. The relative thermal exposure of the cooling apparatus is a parameter that can be optimised according to the characteristics of the specific cooling system 15e.

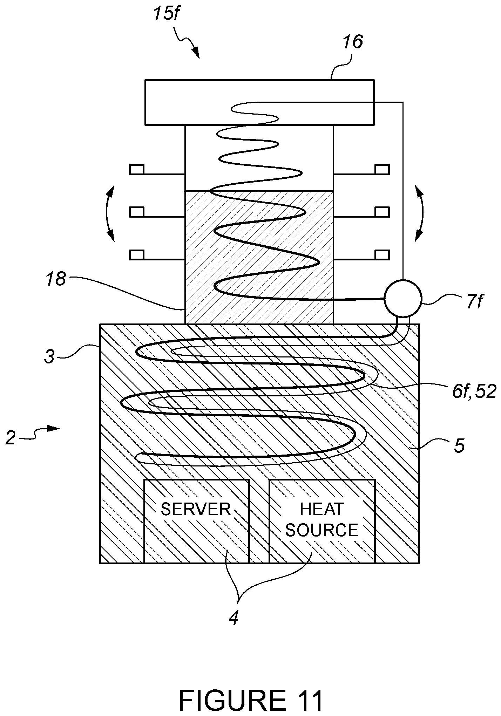

Figure 11 depicts an alternative cooling system 15f which may comprise the same preferable and optional features as the cooling systems 15a, 15b, 15c, 15d, 15e depicted in Figures 2 to 10.

The cooling system 15f of Figure 11 combines the cooling system 15b of Figure 7 with the cooling system 15d of Figure 10.

As can be seen from Figure 11, a cooling apparatus 16 is located upon the roof of the building 3 like the cooling system 15b of Figure 10. The housing 18 is exposed to high temperature air 5 from the building 3. The housing 18 acts as a heat exchanging apparatus as heat is transferred from the high temperature air 5 to the cooling apparatus 16.

In addition, the cooling system 15f comprises heat transfer apparatus in the form of a circulation loop 6f sealed within which is a fluid 52. A portion of the circulation loop 6f is located within the building 3 and acts as an additional heat exchanging apparatus. The fluid 52 of the circulation loop 6f absorbs heat from the high temperature air 5. The heated fluid 52 is channelled within the cooling apparatus 16 which cools the heated fluid 52.

The cooling system 15f comprises two mechanisms to transfer heat from the high temperature air 5 to the cooling apparatus 16, namely convection and a circulation loop 6f. As such, the cooling system 15f advantageously has an improved efficiency of the cooling systems 15b, 15d of figures 7 and 10.

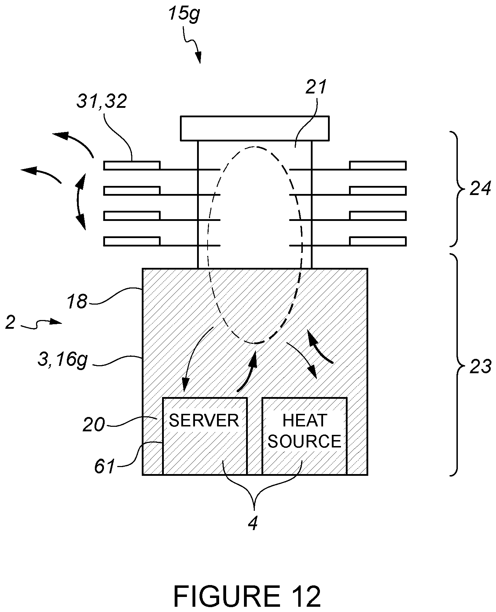

Figure 12 depicts an alternative cooling system 15g which may comprise the same preferable and optional features as the cooling systems 15a, 15b, 15c, 15d, 15e, 15f depicted in Figures 2 to 11.

Instead of the transferring heat from the computer systems 4 housed within a building 3 to a cooling apparatus 16, the building 3 itself is configured to be a cooling apparatus 16g. As such, a heat transfer apparatus is not required. The building 3 houses a first liquid 20 and a second liquid 21. The computer systems 4 and first liquid 20 are located in a first portion 23 of the building 3, towards the base of the building 3, and the second liquid 21 locates within a second portion 24 of the housing 18, above the first liquid 20. The computer systems 4 comprise a fluid tight casing 61 as the computer systems 4 are immersed within the first liquid 20. The fluid tight casing 61 as acts as an interface between the computer systems 4 and the first liquid 20. As such, in this embodiment the heat exchanging apparatus 25 of the cooling system 16 is the fluid tight casing 61. The building 3 further comprises a plurality of independent energy dissipation members 31 such as rods 32.

In operation, the building 3 is fluidly sealed such that the first and second liquids 20, 21 do not leak from the building 3. The building 3 operates as a cooling apparatus 16g in the same way as the cooling apparatus 16 of Figure 3. The first liquid 20 evaporates to form gaseous bubbles 45 which rise through the building 3 and transfers kinetic and thermal energy to the rods 32. The rods 32 transmit the motion and conduct the thermal energy induced by the gaseous bubbles 45 from the first to second ends 33, 34 and dissipate the energy to the external surroundings of the building 3.

Advantageously, the cooling system 15g is simplified as does not require the heat transfer apparatus to transfer heat from the computer systems 4 to a cooling apparatus 16 as the computer systems 4 are located within the cooling apparatus 16g.

The cooling systems 15a, 15b, 15c, 15d, 15e, 15f, 15g of Figures 2 to 12 can cool the high temperature air 5 to the surrounding temperature, for example 20°C. However, these cooling systems 15a, 15b, 15c, 15d, 15e, 15g, 15f cannot cool the high temperature air 5 below the surrounding temperature, 20°C. If the air entering the cooling apparatus 16 was the same temperature as the surroundings, there would be no thermal gradients within the cooling apparatus 16 and heat would not transfer from the air to the first liquid 20.

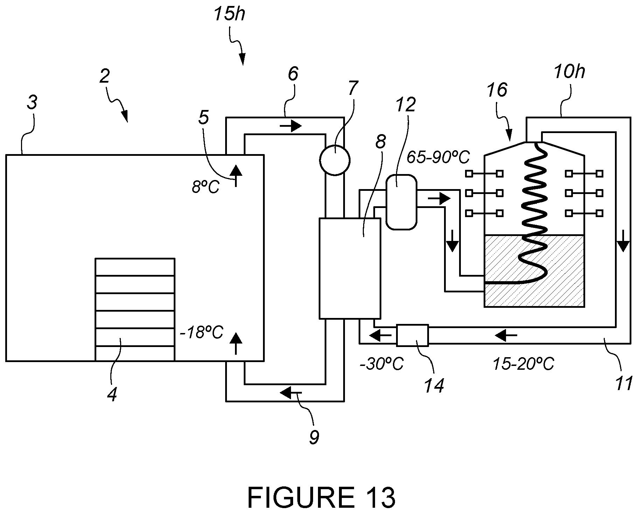

Figure 13 depicts an alternative cooling system 15h which may comprise the same preferable and optional features as the cooling systems 15a, 15b, 15c, 15d, 15e, 15f, 15g depicted in Figures 2 to 12.

The cooling system 15h of Figure 13 is similar to the vapour-compression refrigeration system depicted 1 of Figure 1. However, in contrast to Figure 1, the refrigeration loop 10h of Figure 13 comprises a cooling apparatus 16h instead of a condenser 13. The refrigeration loop 10h is the heat transfer apparatus.

The cooling system 15h of Figure 13 operates in the same way as the cooling system 1 of Figure 1. However, the cooling apparatus 16 condenses the hot compressed gaseous working fluid 11 back to a liquid instead of a conventional condenser 13.

Advantageously, the cooling system 15h can cool high temperature air 5 to a temperature below ambient temperature without the need to power a condenser. As such, the cooling system 15h of Figure 13 is cheaper to operate and more environmentally friendly than the vapour-compression refrigeration system 1 known in the art.

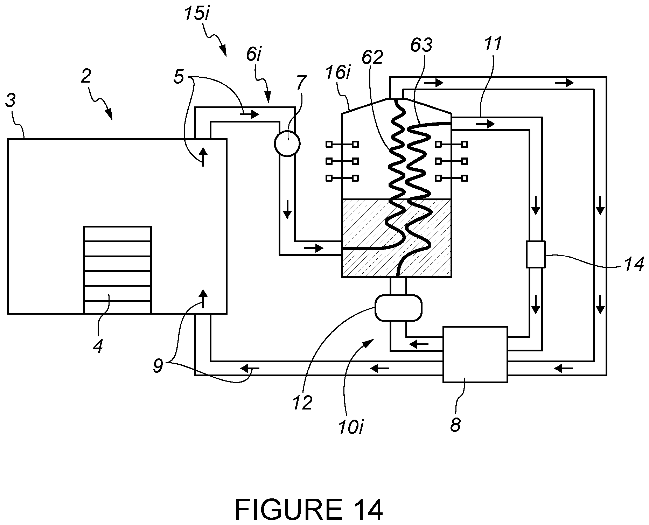

Figure 14 depicts an alternative cooling system 15i which may comprise the same preferable and optional features as the cooling systems 15a, 15b, 15c, 15d, 15e, 15f, 15g, 15h depicted in Figures 2 to 13.

The cooling system 15i of Figure 14 is a combination of the cooling systems 15b, 15h of Figures 2 and 13.

The cooling system 15i of Figure 14 comprises circulation loop 6i and a refrigeration loop 10i. Both the circulation loop 6i and the refrigeration loop 10i are the heat transfer apparatus. The circulation fan 7i circulates high temperature air 5 from a building 3 about the circulation loop 6i to an evaporator 8. However, in contrast to the embodiment of Figure 13, the high temperature air 5 is first channelled through the cooling apparatus 16i before it reaches the evaporator 8. The high temperature air 5 is partially cooled by the cooling apparatus 16i. After which, the resulting air is circulated to the evaporator 8 where it is further cooled by the refrigeration loop 10.

The cooling apparatus 16i is also a component of the refrigeration loop 10i of Figure 14. As such, the cooling apparatus 16i cools both the high temperature air 5 of the circulation loop 6i and the working fluid 11 of the refrigeration loop 10i. The cooling apparatus 16i comprises two heat exchanging apparatus 25, in the form of a first coiled pipe 62 and a second coiled pipe 63. A first coiled pipe 62 forms part of the circulation loop 6i and channels high temperature air 5 through the cooling apparatus 16i. A second coiled pipe 63 forms part of the refrigeration loop 10i and channels working fluid 11 through the cooling apparatus 16i. The high temperature air 5 and working fluid 11 do not mix within the cooling apparatus 16i and more generally the cooling system 15i.

It will be appreciated that thermal capacity of the cooling apparatus 16i is optimised, so that it is sufficiently large to cool both the high temperature air 5 and the working fluid 11. More specifically, the cooling apparatus 16i may be larger and have different first and second fluids 20, 21 in comparison to the cooling systems 15b, 15h of Figures 2 and 13.

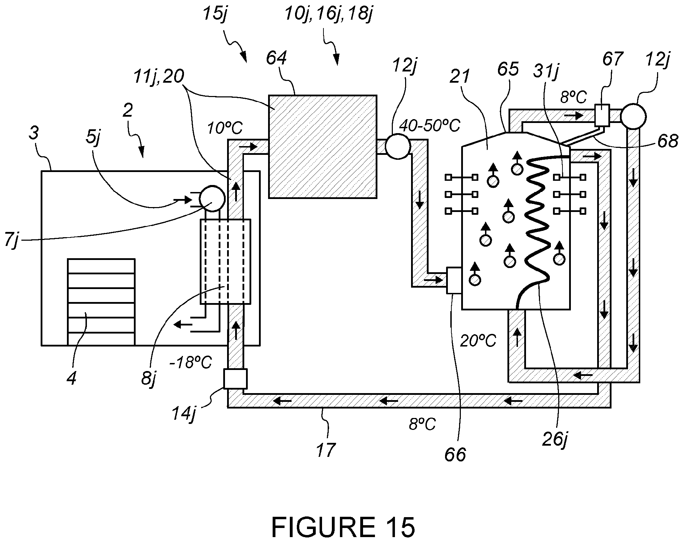

Figure 15 depicts an alternative cooling system 15j which may comprise the same preferable and optional features as the cooling systems 15a, 15b, 15c, 15d, 15e, 15f, 15g, 15h, 15i depicted in Figures 2 to 14.

The cooling system 15j of Figure 15 comprises a sealed refrigeration loop 10j which contains a working fluid 11j. In the embodiment of Figure 15, the working fluid 11j also acts as first liquid 20 of a cooling apparatus 16j.

The refrigeration loop 10j comprises an evaporator 8j located in the building 3 of the data centre 2. The evaporator 8j transfers heat from high temperature air 5j (for example 10°C) within the building 3 to the working fluid 11j of the refrigeration loop 10j inducing a phase change from a liquid to a gas.

The gaseous working fluid 11j circulates to and accumulates in a first chamber 64. The first chamber 64 is fluidly connected to a second chamber 65. Located between the first and second chamber 64, 65 is a compressor 12j and then a relief valve 66. The compressor 12j compresses the gaseous working fluid 11j to a hot liquid working fluid 11j with a temperature, for example, of 40 to 50°C. The relief valve 66 releases the hot liquid working fluid 11j into the second chamber 65. The relief valve 66 controls the flow and pressure of the hot liquid working fluid 11j entering the second chamber 65. The working fluid 11j is compressed before entering the second chamber 65 to increase the heat capacity.

The second chamber 65 comprises a second liquid 21. The second liquid 21 has a lower density but higher boiling point than the liquid working fluid 11j. As the hot liquid working fluid 11j enters the second chamber 65 and mixes with the second liquid 21. The hot liquid working fluid 11j decompresses to a gas and bubbles up through the second chamber 65 dissipating energy to independent energy dissipating members 31j extending through the second chamber 65, as described in the in the context of the cooling apparatus 16 of the first to ninth embodiments of Figures 2 to 14. As such, the working fluid 11j acts as the first liquid 20.

The gaseous working fluid 11j is cooled to, for example, to 8°C. The cooled gaseous working fluid 11j is siphoned off the second chamber 65 and further circulated about the refrigeration loop 10j where it is compressed by another compressor 12j increasing the temperature to, for example 20°C. The compressors 12j may also act as pumps to assist with circulating the working fluid 11j about the refrigeration loop 10j. The compressed working fluid 11j is circulated through a coiled pipe 26j extending through the second chamber 65. The coiled pipe 26 acts as a heat exchanging apparatus and transfers heat from the compressed working fluid 11j to the fluids within the second chamber 65 thereby further cooling the working fluid 11f.

The cooled working fluid 11f (8°C) condenses to a liquid and is circulated back to the building 3 via an expansion valve 14j. The expansion valve 14j reduces the pressure of the cooled working fluid 11f, further reducing the pressure to, for example -38°C. The cold (-38 °C) uncompressed liquid working fluid 11f is recirculated into the evaporator 8j where, by means of thermal diffusion, heat again transfers from the high temperature air 5j to the working fluid 11j. The cycle repeats continually cooling the high temperature air 5j of the building 3 to below ambient temperature.

The housing 18j of the cooling apparatus 16j of Figure 15 comprises the combination of the first chamber 64, the second chambers 65 and pipes 17 forming the refrigeration loop 10j. The first liquid 20 is also the working fluid 11j and located throughout the refrigeration loop 10j. This embodiment demonstrates the housing 18j of the cooling apparatus 16j does not have to take the form of a unitary chamber and may more generally comprises multiple chambers in combination with connecting pipes. Advantageously, the housing 18 comprising multiple chambers can provide greater flexibility when designing an appropriate cooling apparatus 16 for a specific cooling system 15.

Furthermore, this embodiment also demonstrates the working fluid 11j of a refrigeration loop 10j may also act as the first liquid 20 of a cooling apparatus 16j. Advantageously, this obviates the need for a cooling system 15 to comprise three fluids, namely a working fluid, first liquid and a second liquid when it can operate with two fluids.

As an additional feature, the refrigeration loop 10j of Figure 15 may comprise a separator 67. The cooled working fluid 11j siphoned off from the second chamber 65 passes through the separator 67 before being further circulated about the refrigeration loop 10j. The separator 67 separates any residual second liquid 21 mixed with the working fluid 11j exiting the second chamber 65. The separated second liquid 21 is channelled back into the second chamber 65 by means of a drain 68. The separator 67 ensures the second liquid 21 is confined to the second chamber 65 and only the working fluid 11j is circulated about the refrigeration loop 10j.

The separator 67 is depicted in Figure 15 as a separate component of the refrigeration loop 10j, yet it will be appreciated the separator 67 may also take the form as an integral component of the compressor 12j located at the exit of the second chamber 65.

As a further additional feature, the cooling system 15j of Figure 15 may comprise a circulation fan 7j to draw high temperature air 5j into and through the evaporator 8j. Alternatively, the evaporator 8j may comprise an integral circulation fan to draw high temperature air 5j into and through the evaporator 8j.

The cooling systems 15 of Figures 2 to 15 are described as cooling a data centre 2 and specifically, computer systems 4, within a building 3. It will be appreciated that the cooling systems 15 are not limited to cooling a data centre 2 and may be employed to cool any suitable body such as a heat source or building. For example, the cooling systems 15 may be employed to cool an office building or even a chiller room for chilled food products.

### Method of Manufacturing a Cooling apparatus

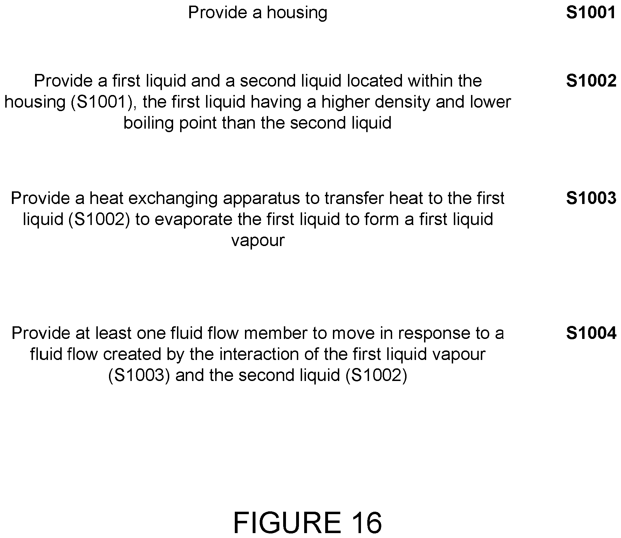

Figure 16 shows a flow chart for a method of manufacturing the cooling apparatus 16. The method comprises: providing a housing (S1001); providing a first and second liquid located within the housing, the first liquid having a higher density and lower boiling point than the second liquid (S1002); providing a heat transfer apparatus to transfer heat to the first liquid to evaporate the first liquid to form a first liquid vapour (S1003); and providing a plurality of independent energy dissipating members that extend through the housing, wherein the independent energy dissipating member move in response to a fluid flow created by the interaction of the first liquid vapour and second liquid, and transfer heat to a volume external to the housing.

In addition, the method of manufacturing the cooling apparatus 16 may optionally comprise characterising a body which is to be cooled, such as a data centre 2. For example, this may include characterising properties such as the temperature of the body without any cooling, a target temperature of the body with cooling, the temperature variability of the body, the dimensions, shape, composition, location and accessibility of the body.

As a further addition, the method of manufacturing the cooling apparatus 16 may optionally comprise utilising the characteristics of the body to determine the optimum parameters of a cooling apparatus 16. For example, this optimisation process may include determining: the dimensions and shape of the cooling apparatus 16; the volume, relative ratio and chemical composition of the first and second liquids 20, 21; the distribution, orientation, dimensions, design and material composition of the rods 32; if pellets 47 are required, if a condensing loop 48 is required; if a sink 50 is required; if storage tanks 51 are required; the form of the heat exchanging apparatus 25, for example if multiple coiled pipes 26 are required; and how to cooling apparatus 16 is to be integrated into a cooling system. As an example of the parameter dependency, the higher the temperature of the body and the greater the difference between the uncooled temperature of the body and desired cooled temperature of the body, the greater required cooling capacity of the cooling apparatus 16. When choosing the first and second liquids 20, 21 factors such as the heat capacity, relative density and relative boiling points are key considerations. It is advantageous to optimise the cooling apparatus 16 as this ensures the cooling apparatus 16 can operate, in other words, the body will provide enough heat to evaporate any quantity of the first liquid 20. Furthermore, the optimisation ensures the cooling apparatus 16 can operate efficiently.

### Method of Manufacturing a Cooling System

A method of manufacturing a cooling system 15 comprises providing a cooling apparatus 16 in accordance with the flow chart depicted in Figure 16, as described above, and providing a body, such as a data centre 2 which is to be cooled.

As an additional or alternative feature, the method of manufacturing a cooling system 15 may optionally comprise providing a heat transfer apparatus to transfer heat from the body to the cooling apparatus 16. The heat transfer apparatus may take the form of one or more circulation loops 6 in conjunction with a circulation fan 7 or conductive members 58. In addition, or alternatively, the cooling apparatus 16 may be located above the body such that convection transfers heat from the body to the cooling apparatus 16.

As a further additional or alternative feature, the method of manufacturing a cooling system 15 may optionally comprise providing a refrigeration loop 10. The refrigeration loop 10 operates a thermodynamic cycle known in the art to cool a working fluid 11 below ambient temperature.

The cooling systems 15 disclosed herein have numerous advantages. Various advantageous of each cooling system 15 have been presented. In general, the cooling systems 15 all comprises a cooling apparatus 16 which passively dissipates heat. The cooling apparatus 16 can operate without drawing electrical power and so is financially favourable and environmentally friendly.

Advantageously the cooling apparatus 16 can be incorporated into numerous cooling systems 15. For example, the cooling apparatus 16 can cool air or a fluid in a circulation loop 6. Furthermore, the cooling apparatus 16 can be retrofitted to existing cooling systems such as a vapour-compression refrigeration system by replacing the condenser. In addition, the cooling apparatus 16 is suitable for a cooling system 15 comprising a circulation loop 6 and refrigeration loop 10. The cooling apparatus 16 can cool both the fluid in the circulation loop 6 and the working fluid 11 in the refrigeration loop 10. Such cooling systems 15 are capable of cooling below ambient temperature.

The cooling apparatus 16 does not rely on conventional thermodynamic cycles, but instead provides an alternative mechanism for dissipating heat by utilising a phase change of the first liquid 20 to create fluid flows and the subsequent interaction with the rods 32. The cooling apparatus 16 has minimal moving components, reducing the amount of maintenance that may be required and maximising the lifetime of the device.

Furthermore, the cooling apparatus 16 is scalable as can be adapted for different bodies to be cooled. As such, the dimensions of the cooling apparatus can be adapted to the desired size and resulting expense. The cooling apparatus 16 is a sealed device with minimal moving components so is relatively safe.

The cooling apparatus 16 is customisable as the rods 32, and specifically the conductive surfaces 39 and conductive protrusions 41, can be optimised for a specific cooling system 15.

A cooling apparatus is disclosed. The cooling apparatus comprises a housing, a first liquid and a second liquid located within the housing. The first liquid has a higher density and lower boiling point than the second liquid. The cooling apparatus further comprises a heat exchanging apparatus to transfer heat to the first liquid to evaporate the first liquid to form a first liquid vapour. The cooling apparatus also comprises a plurality of independent energy dissipating members that extend through the housing. These members move in response to a fluid flow created by the interaction of the first liquid vapour and the second liquid and transfer heat to a volume external to the housing. The cooling apparatus can cool a body whilst drawing minimal or even no electrical power. As such the cooling apparatus is environmentally friendly and cheaper to operate.

Throughout the specification, unless the context demands otherwise, the terms "comprise" or "include", or variations such as "comprises" or "comprising", "includes" or "including" will be understood to imply the inclusion of a stated integer or group of integers, but not the exclusion of any other integer or group of integers. Furthermore, unless the context clearly demands otherwise, the term "or" will be interpreted as being inclusive not exclusive.

The foregoing description of the invention has been presented for purposes of illustration and description and is not intended to be exhaustive or to limit the invention to the precise form disclosed. The described embodiments were chosen and described in order to best explain the principles of the invention and its practical application to thereby enable others skilled in the art to best utilise the invention in various embodiments and with various modifications as are suited to the particular use contemplated. Therefore, further modifications or improvements may be incorporated without departing from the scope of the invention as defined by the appended claims.

## Claims

1. A cooling apparatus (16) comprising:
a housing (18);
a first liquid (20) and a second liquid (21) located within the housing (18),
a heat exchanging apparatus (25) to transfer heat to the first liquid (20) to evaporate a quantity of the first liquid (20) to form a first liquid vapour (45); and
a plurality of independent energy dissipating members (31) that extend through the housing (18), **characterized in that** the first liquid (20) has a higher density and lower boiling point than the second liquid (21); and
wherein the independent energy dissipating members (31) move ir response to a fluid flow created by the interaction of the first liquid vapour (45) and the second liquid (21) and transfer heat to a volume external to the housing (18).

2. A cooling apparatus (16) as claimed in claim 1 wherein, the housing (18) comprises a unitary chamber or two or more chambers (64, 65) with one or more pipes (17) connecting the two or more chambers (64, 65).

3. A cooling apparatus (16) as claimed in either of claims 1 or 2 wherein, the first liquid (20) is 1-Chloro-3,3,3-trifluoropropene (R1233ZD) and the second liquid (21) is de-mineralised water; or the first liquid (20) is Dichlorotrifluoroethane and the second liquid (21) is de-mineralised water; or the first liquid (20) is 1,2-Dichlorotetrafluoroethane and the second liquid (21) is de-mineralised water; or the first liquid (20) is 1,1,1,3,3,3-Hexafluoropropane and the second liquid (21) is de-mineralised water; or the first liquid (20) is R1234 YF and the second liquid (21) is de-mineralised water; or the first liquid (20) is R-1234ze (Trans-1,3,3,3-tetrafluoroprop-1-ène) and the second liquid (21) is de-mineralised water.

4. A cooling apparatus (16) as claimed in any of the preceding claims wherein, the cooling apparatus (16) comprises three or more liquids.

5. A cooling apparatus (16) as claimed in any of the preceding claims wherein, the heat exchanging apparatus (25) comprises one or more pipes (17), one or more coiled pipes (26), a first portion (23) of the housing (18), one or more conductive members (58), a fluid tight casing (61) and or an evaporator (8).

6. A cooling apparatus (16) as claimed in any of the preceding claims wherein, the plurality of independent energy dissipation members (31) is a plurality of rods (32), a first end (33) of each rod extends into an interior volume (22) of the housing (18), a second end (34) of each rod extends into a volume external to the housing (18) and a mounting portion (35) of each rod is mounted to the housing (18) and optionally the first end (33) and or second end (34) of each rod of the plurality of rods (32) comprises an enlarged region (38) with at least one conductive surface (39).

7. A cooling apparatus (16) as claimed in any of the preceding claims wherein the cooling apparatus (16) further comprises:
a condensing loop (48) and or
a sink (50) and or
a pumping system (44) and or one or more storage tanks (51) and or
one or more compressors (12) and or a relief valve (66) and or an expansion valve (14).

8. A cooling system (15) comprising the cooling apparatus (16) as claimed in any of claims 1 to 7, a body to be cooled and optionally a heat transfer apparatus.

9. A cooling system (15) as claimed in claim 8 wherein, the heat transfer apparatus comprises a circulation loop (6) and or one or more conductive members (58).

10. A cooling system (15) as claimed in claim 9 wherein, the circulation loop (6) comprises: air; or a fluid (52); or a first loop (53) with a first fluid (55) and a second loop (54) with a second fluid (56).

11. A cooling system (15) as claimed in claim 8 wherein, the body is the cooling apparatus (16).

12. A cooling system (15) as claimed in claims 8 to 10 wherein, the cooling system (15) further comprises a refrigeration loop (10) with a working fluid (11) and optionally both the refrigeration loop (10) and circulation loop (6) pass through the cooling apparatus (16).

13. A method of manufacturing a cooling apparatus (16) comprising,
• providing a housing (18)
• providing a first liquid (20) and a second liquid (21) located within the housing (18), the first liquid (20) having a higher density and lower boiling point than the second liquid (21);
• providing a heat exchanging apparatus (25) to transfer heat to the first liquid (20) to evaporate a quantity of the first liquid (20) to form a first liquid vapour (45); and
• providing a plurality of independent energy dissipating members (31) that extend through the housing (18), wherein the independent energy dissipating members (31) move in response to a fluid flow created by the interaction of the first liquid vapour (45) and the second liquid (21) and transfer heat to a volume external to the housing (18).

14. A method of manufacturing a cooling apparatus (16) as claimed in claim 13 wherein, the method further comprises determining the characteristics of a body to be cooled by the cooling apparatus (16) and optionally determining optimum parameters of a cooling apparatus (16) for use with the body.

15. A method of manufacturing a cooling system (15) comprising,
• providing a cooling apparatus (16) in accordance with the method as claimed in claims 13 or 14; and
• providing a body to be cooled.

## Patentansprüche

1. eine Kühlvorrichtung (16), die Folgendes umfasst:
ein Gehäuse (18);
eine erste Flüssigkeit (20) und eine zweite Flüssigkeit (21), die sich innerhalb des Gehäuses (18) befinden,
eine Wärmeaustauschvorrichtung (25) zum Übertragen von Wärme auf die erste Flüssigkeit (20), um eine Menge der ersten Flüssigkeit (20) zu verdampfen und einen ersten Flüssigkeitsdampf (45) zu bilden, und
eine Vielzahl unabhängiger Energieableitungselemente (31), die sich durch das Gehäuse (18) erstrecken, **dadurch gekennzeichnet, dass** die erste Flüssigkeit (20) eine höhere Dichte und einen niedrigeren Siedepunkt als die zweite Flüssigkeit (21) aufweist; und wobei sich die unabhängigen Energieableitungselemente (31) als Reaktion auf einen Fluidstrom bewegen, der durch die Wechselwirkung des ersten Flüssigkeitsdampfs (45) und der zweiten Flüssigkeit (21) erzeugt wird, und Wärme auf ein Volumen außerhalb des Gehäuses (18) übertragen.

2. Eine Kühlvorrichtung (16) gemäß Anspruch 1, wobei das Gehäuse (18) eine einheitliche Kammer oder zwei oder mehr Kammern (64, 65) mit einem oder mehreren Rohren (17) umfasst, die die zwei oder mehr Kammern (64, 65) verbinden.

3. Eine Kühlvorrichtung (16) nach Anspruch 1 oder 2, wobei die erste Flüssigkeit (20) 1-Chlor-3,3,3-trifluorpropen (R1233ZD) und die zweite Flüssigkeit (21) demineralisiertes Wasser ist oder die erste Flüssigkeit (20) Dichlortrifluorethan und die zweite Flüssigkeit (21) demineralisiertes Wasser ist oder die erste Flüssigkeit (20) 1,2-Dichlortetrafluorethan und die zweite Flüssigkeit (21) demineralisiertes Wasser ist oder die erste Flüssigkeit (20) 1,1,1,3,3,3-Hexafluorpropan und die zweite Flüssigkeit (21) demineralisiertes Wasser ist oder die erste Flüssigkeit (20) R1234 YF und die zweite Flüssigkeit (21) demineralisiertes Wasser ist oder die erste Flüssigkeit (20) R-1234ze (Trans-1,3,3,3-Tetrafluorprop-1-en) und die zweite Flüssigkeit (21) demineralisiertes Wasser ist.

4. Eine Kühlvorrichtung (16) nach einem der vorhergehenden Ansprüche, wobei die Kühlvorrichtung (16) drei oder mehr Flüssigkeiten umfasst.

5. Eine Kühlvorrichtung (16) nach einem der vorhergehenden Ansprüche, wobei die Wärmeaustauschvorrichtung (25) ein oder mehrere Rohre (17), ein oder mehrere gewickelte Rohre (26), einen ersten Teil (23) des Gehäuses (18), ein oder mehrere leitfähige Elemente (58), eine fluiddichte Ummantelung (61) und/oder einen Verdampfer (8) umfasst.

6. Eine Kühlvorrichtung (16) nach einem der vorhergehenden Ansprüche, wobei die Vielzahl unabhängiger Energieableitungselemente (31) eine Vielzahl von Stäben (32) ist, ein erstes Ende (33) jedes Stabs in ein Innenvolumen (22) des Gehäuses (18) hineinragt, ein zweites Ende (34) jedes Stabs in ein Volumen außerhalb des Gehäuses (18) hineinragt und ein Montageabschnitt (35) jedes Stabs am Gehäuse (18) montiert ist und optional
das erste Ende (33) und/oder zweite Ende (34) jedes Stabs der Vielzahl von Stäben (32) einen vergrößerten Bereich (38) mit mindestens einer leitfähigen Oberfläche (39) umfasst.

7. Eine Kühlvorrichtung (16) gemäß einem der vorhergehenden Ansprüche, wobei die Kühlvorrichtung (16) zudem Folgendes umfasst:
eine Kondensationsschleife (48) und/oder
eine Spüle (50) und/oder
ein Pumpensystem (44) und/oder einen oder mehrere Lagertanks (51) und/oder
einen oder mehrere Kompressoren (12) und/oder ein Überdruckventil (66) und/oder ein Expansionsventil (14).

8. Ein Kühlsystem (15), das die Kühlvorrichtung (16) gemäß einem der Ansprüche 1 bis 7, einen zu kühlenden Körper und optional eine Wärmeübertragungsvorrichtung umfasst.

9. Ein Kühlsystem (15) gemäß Anspruch 8, wobei die Wärmeübertragungsvorrichtung eine Zirkulationsschleife (6) und/oder ein oder mehrere leitfähige Elemente (58) umfasst.

10. Ein Kühlsystem (15) gemäß Anspruch 9, wobei die Zirkulationsschleife (6) Folgendes umfasst: Luft oder ein Fluid (52) oder eine erste Schleife (53) mit einem ersten Fluid (55) und eine zweite Schleife (54) mit einem zweiten Fluid (56).

11. Ein Kühlsystem (15) gemäß Anspruch 8, wobei der Körper die Kühlvorrichtung (16) ist.

12. Ein Kühlsystem (15) gemäß den Ansprüchen 8 bis 10, wobei das Kühlsystem (15) zudem eine Kühlschleife (10) mit einem Arbeitsfluid (11) umfasst und wahlweise sowohl die Kühlschleife (10) als auch die Zirkulationsschleife (6) durch die Kühlvorrichtung (16) verlaufen.

13. Ein Verfahren zur Herstellung einer Kühlvorrichtung (16), das Folgendes umfasst:
• Bereitstellen eines Gehäuses (18)
• Bereitstellen einer ersten Flüssigkeit (20) und einer zweiten Flüssigkeit (21), die sich innerhalb des Gehäuses (18) befinden, wobei die erste Flüssigkeit (20) eine höhere Dichte und einen niedrigeren Siedepunkt aufweist als die zweite Flüssigkeit (21);
• Bereitstellen einer Wärmeaustauschvorrichtung (25) zum Übertragen von Wärme auf die erste Flüssigkeit (20), um eine Menge der ersten Flüssigkeit (20) zu verdampfen, um einen ersten Flüssigkeitsdampf (45) zu bilden, und
• Bereitstellen einer Vielzahl unabhängiger Energieableitungselemente (31), die sich durch das Gehäuse (18) erstrecken, wobei sich die unabhängigen Energieableitungselemente (31) als Reaktion auf einen Fluidstrom bewegen, der durch die Wechselwirkung des ersten Flüssigkeitsdampfs (45) und der zweiten Flüssigkeit (21) erzeugt wird, und Wärme auf ein Volumen außerhalb des Gehäuses (18) übertragen.

14. Ein Verfahren zur Herstellung einer Kühlvorrichtung (16) gemäß Anspruch 13, wobei das Verfahren zudem das Bestimmen der Eigenschaften eines durch die Kühlvorrichtung (16) zu kühlenden Körpers und optional das Bestimmen optimaler Parameter einer Kühlvorrichtung (16) zur Verwendung mit dem Körper umfasst.

15. Ein Verfahren zur Herstellung eines Kühlsystems (15), das Folgendes umfasst:
• Bereitstellen einer Kühlvorrichtung (16) gemäß dem Verfahren gemäß Anspruch 13 oder 14 und
• Bereitstellen eines zu kühlenden Körpers.

## Revendications

1. Appareil de refroidissement (16) comprenant :
un boîtier (18) ;
un premier liquide (20) et un second liquide (21) situés à l'intérieur du boîtier (18),
un appareil d'échange thermique (25) pour transférer de la chaleur vers le premier liquide (20) afin d'évaporer une quantité du premier liquide (20) pour former une vapeur du premier liquide (45) ; et
une pluralité d'éléments de dissipation d'énergie indépendants (31) qui traversent le boîtier (18), **caractérisé en ce que** le premier liquide (20) possède une densité supérieure et un point d'ébullition inférieur à ceux du second liquide (21) ; et dans lequel les éléments de dissipation d'énergie indépendants (31) se déplacent en réponse à un flux de fluide créé par l'interaction entre la vapeur du premier liquide (45) et le second liquide (21) et transfèrent de la chaleur vers un volume externe au boîtier (18).

2. Appareil de refroidissement (16) selon la revendication 1, dans lequel le boîtier (18) comprend une chambre unitaire ou deux chambres ou plus (64, 65) avec une ou plusieurs conduites (17) reliant les deux chambres ou plus (64, 65).

3. Appareil de refroidissement (16) selon l'une quelconque des revendications 1 ou 2, dans lequel le premier liquide (20) est du 1-chloro-3,3,3-trifluoropropène (R1233ZD) et le second liquide (21) est de l'eau déminéralisée ; ou le premier liquide (20) est du dichlorotrifluoroéthane et le second liquide (21) est de l'eau déminéralisée ; ou le premier liquide (20) est du 1,2-dichlorotétrafluoroéthane et le second liquide (21) est de l'eau déminéralisée ; ou le premier liquide (20) est du 1,1,1,3,3,3-hexafluoropropane et le second liquide (21) est de l'eau déminéralisée ; ou le premier liquide (20) est du R1234 YF et le second liquide (21) est de l'eau déminéralisée ; ou le premier liquide (20) est du R-1234ze (trans-1,3,3,3-tétrafluoroprop-1-ène) et le second liquide (21) est de l'eau déminéralisée.

4. Appareil de refroidissement (16) selon l'une quelconque des revendications précédentes, l'appareil de refroidissement (16) comprenant trois liquides ou plus.

5. Appareil de refroidissement (16) selon l'une quelconque des revendications précédentes, dans lequel l'appareil d'échange thermique (25) comprend une ou plusieurs conduites (17), une ou plusieurs conduites enroulées (26), une première portion (23) du boîtier (18), un ou plusieurs éléments conducteurs (58), un carter étanche (61) et/ou un évaporateur (8).

6. Appareil de refroidissement (16) selon l'une quelconque des revendications précédentes, dans lequel la pluralité d'éléments de dissipation d'énergie indépendants (31) est une pluralité de tiges (32), une première extrémité (33) de chaque tige s'étend dans un volume intérieur (22) du boîtier (18), une seconde extrémité (34) de chaque tige s'étend dans un volume externe au boîtier (18) et une portion de montage (35) de chaque tige est montée sur le boîtier (18) et éventuellement
la première extrémité (33) et/ou la seconde extrémité (34) de chaque tige de la pluralité de tiges (32) comprend une région élargie (38) avec au moins une surface conductrice (39).

7. Appareil de refroidissement (16) selon l'une quelconque des revendications précédentes, l'appareil de refroidissement (16) comprenant en outre :
une boucle de condensation (48) et/ou
un évier (50) et/ou
un système de pompage (44) et/ou un ou plusieurs réservoirs de stockage (51) et/ou
un ou plusieurs compresseurs (12) et/ou une soupape de décompression (66) et/ou une soupape de détente (14).

8. Système de refroidissement (15) comprenant l'appareil de refroidissement (16) selon l'une quelconque des revendications 1 à 7, un corps à refroidir et éventuellement un appareil de transfert thermique.

9. Système de refroidissement (15) selon la revendication 8, dans lequel l'appareil de transfert thermique comprend une boucle de circulation (6) et/ou un ou plusieurs éléments conducteurs (58).

10. Système de refroidissement (15) selon la revendication 9, dans lequel la boucle de circulation (6) comprend : de l'air ; ou un fluide (52) ; ou une première boucle (53) avec un premier fluide (55) et une seconde boucle (54) avec un second fluide (56).

11. Système de refroidissement (15) selon la revendication 8, dans lequel le corps est l'appareil de refroidissement (16).

12. Système de refroidissement (15) selon les revendications 8 à 10, le système de refroidissement (15) comprenant en outre une boucle de réfrigération (10) avec un fluide de travail (11) et éventuellement à la fois la boucle de réfrigération (10) et la boucle de circulation (6) traversent l'appareil de refroidissement (16).

13. Procédé de fabrication d'un appareil de refroidissement (16) consistant à,
• mettre en place un boîtier (18)
• mettre en place un premier liquide (20) et un second liquide (21) situés dans le boîtier (18), le premier liquide (20) ayant une densité supérieure et un point d'ébullition inférieur à ceux du second liquide (21) ;
• mettre en place un appareil d'échange thermique (25) pour transférer de la chaleur vers le premier liquide (20) afin d'évaporer une quantité du premier liquide (20) pour former une vapeur du premier liquide (45) ; et
• mettre en place une pluralité d'éléments de dissipation d'énergie indépendants (31) qui traversent le boîtier (18), dans lequel les éléments de dissipation d'énergie indépendants (31) se déplacent en réponse à un flux de fluide créé par l'interaction entre la vapeur du premier liquide (45) et le second liquide (21) et transfèrent de la chaleur vers un volume externe au boîtier (18).

14. Procédé de fabrication d'un appareil de refroidissement (16) selon la revendication 13, le procédé comprenant en outre la détermination des caractéristiques d'un corps à refroidir par l'appareil de refroidissement (16) et éventuellement la détermination de paramètres optimaux d'un appareil de refroidissement (16) à utiliser avec le corps.

15. Procédé de fabrication d'un système de refroidissement (15) consistant à,
• mettre en place un appareil de refroidissement (16) selon le procédé des revendications 13 ou 14 ; et
• mettre en place un corps à refroidir.
